# EUROPÄISCHE PATENTSCHRIFT

(11) **EP 1 186 684 B1**
(45) Veröffentlichungstag und Bekanntmachung des Hinweises auf die Patenterteilung: **07.10.2009**
(21) Anmeldenummer: 01120376.7
(22) Anmeldetag: 25.08.2001
(51) Int. Cl.: C23C 14/50, C23C 14/32, C23C 14/34, C23C 14/56

(54) **Abschattungsring für Plasmabeschichtungsanlagen**
Shadow ring for plasma coating apparatuses
Anneau protecteur pour appareillages de revêtement par plasma

(30) Priorität: 08.09.2000 DE 10044419
(43) Veröffentlichungstag der Anmeldung: 13.03.2002
(73) Patentinhaber: Infineon Technologies AG, 81669 München (DE)
(72) Erfinder: Foerster, Jürgen, 93105 Tegernheim (DE); Hecht, Franz, 93170 Bernhardswald (DE); Mussger, Werner, 93138 Lappersdorf (DE); Frank, Manfred, 93152 Nittendorf (DE); Kuhr, Joerg, 93142 Maxhütte Degelhof (DE); Rausch, Norbert, 93197 Zeitlarn (DE)
(74) Vertreter: Patentanwälte Westphal, Mussgnug & Partner

(56) Entgegenhaltungen:
- CH-A- 631 638
- US-A- 5 855 687

## Beschreibung

Die vorliegende Erfindung ist auf einen Abschattungsring für scheibenförmige Werkstücke in Plasmabeschichtungsanlagen gerichtet.

In Plasmabeschichtungs- oder Sputteranlagen werden scheibenförmige Werkstücke, meistens Wafer zur Halbleiterproduktion, auf einer Hebeeinrichtung plaziert, woraufhin sie mittels Kathodenstrahlzerstäubung oder ähnlichen Verfahren mit dem gewünschten Material beschichtet werden.

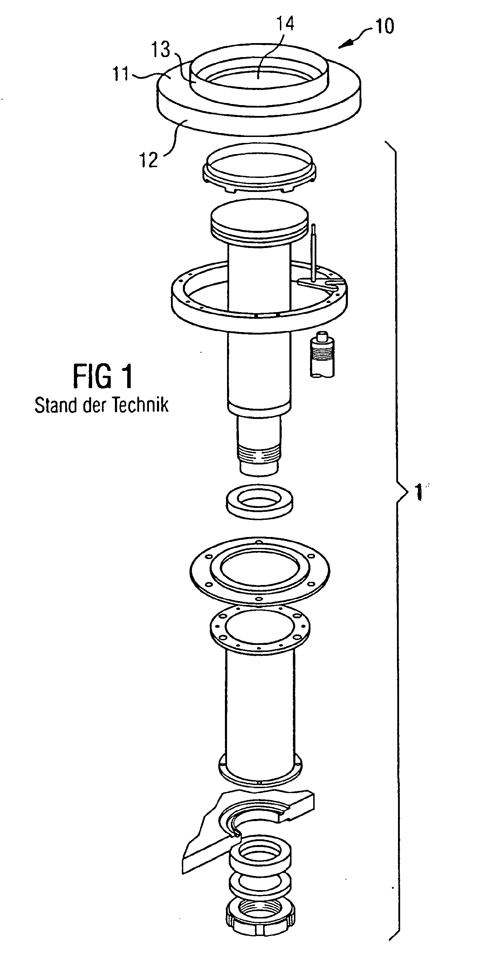

Figur 1 zeigt eine solche vorbekannte, in einer Plasmabeschichtungsanlage angeordnete Vorrichtung. Diese besteht aus einem Unterbau 1, auf den ein Abschattungsring 10 aufgelegt wird. Der Abschattungsring 10 besteht aus einem Auflagebereich 11, an den ein Kragen 12 angesetzt und auf den ein Kranzring 13 aufgesetzt ist. Der Kranzring 13 weist zwei senkrecht aufgestellte Wände, eine Innenwand und eine Außenwand auf und bildet in seinem Inneren eine Ringöffnung 14. Das scheibenförmige Werkstück, beispielsweise ein Wafer, wird durch die Ringöffnung 14 zugeführt und auf den inneren Teil des Auflagebereichs 11 aufgelegt. In der dargestellten Ausführungsform weist auch der Auflagebereich 11 eine Öffnung auf, so daß das scheibenförmige Werkstück lediglich mit seinen Außenrändern auf dem Auflagebereich 11 zu liegen kommt.

Innerhalb des Kranzrings 13 sind häufig Aussparungen angeordnet, beispielsweise halbkreisförmige Aussparungen an der Ringöffnung im Auflagebereich 11, welche dem Durchtritt von Hebestempeln dienen, die nach der Beschichtung in der Lage sind, das Werkstück nach oben zu bewegen und es einem Entnahmezugriff zugänglich zu machen.

CH 631 638 A zeigt einen Haltering mit einer ringförmigen Schulter für die Auflage eines Substrats. US 5 855 6887 A zeigt einen Abschirmring, der auf einen Suszeptor aufgesetzt wird, wobei die Innenfläche des Abschirmrings nach oben hin verjüngt ist.

Es hat sich jedoch gezeigt, daß bei Verwendung eines senkrechten Kranzrings 13 bei herkömmlichen Abschattungsringen eine Beschichtung der Rückseite nicht zuverlässig vermieden werden kann. Seitlich auftreffende Teilchen, welche am Kranzring vorbei in den Innenbereich mit dem Werkstück gelangen, können teils unter Abprallen vom Auflagebereich 11 noch an die Rückseite flacher Werkstücke gelangen, insbesondere, wenn diese eine gerundete Seitenkante haben, wie dies bei Wafern häufig der Fall ist. Eine solche partielle Beschichtung des Rückseitenrands des Werkstücks ist jedoch unerwünscht, da es bei späteren Herstellschritten, beispielsweise von Halbleitern, häufig wieder entfernt werden muß. Diese Entfernung ist aufwendig und damit kostenintensiv.

Es wäre somit vorteilhaft, eine rückseitige Beschichtung des Werkstücks von vornherein zu unterbinden. Es ist die Aufgabe der vorliegenden Erfindung, dieses Ziel zu erreichen.

Diese Aufgabe wird gelöst durch die Bereitstellung eines neuartigen Abschattungsrings für scheibenförmige Werkstücke in Plasmabeschichtungsanlagen gemäß dem unabhängigen Patentanspruch 1. Weitere vorteilhafte Ausgestaltungen, Aspekte und Details der vorliegenden Erfindung ergeben sich aus den abhängigen Patentansprüchen, der Beschreibung und den beigefügten Zeichnungen.

Das Grundprinzip der vorliegenden Erfindung besteht darin, eine formoptimierte Ausprägung des Kranzrings des Abschattungsrings bereitzustellen, die gleichzeitig zwei Bedingungen erfüllen muß:
- einerseits soll zumindest ein Teil des Kranzrings nach innen geneigt sein, um solche Beschichtungspartikel, welche ansonsten auf die Rückseite des scheibenförmigen Werkstücks gelangen würden, noch abfangen zu können;
- andererseits soll der Kranzring stets einen Abstand in Richtung auf das Werkstück einhalten, der eine Entnahme des Werkstücks durch den Kranzring gestattet.

Auch die Abschattungsringe unterliegen in Plasmabeschichtungsanlagen einer Beschichtung. Dies führt dazu, daß sich im Laufe einer vorgegebenen Einsatzdauer die Dimensionen des Abschattungsrings verändern. Während alle Teile des Abschattungsrings dicker werden, verkleinern sich gleichzeitig die Öffnungen, die im Abschattungsring angebracht sind. Durch das Aufwachsen von Beschichtungsmaterial sinkt auch der Durchmesser oder eine sonstige Flächendimensionierung (bei nicht kreisförmigen Ringöffnungen) der Ringöffnung des Kranzrings, durch die Werkstücke zugeführt und wieder entfernt werden. Ein Abschattungsring kann nur dann einsatzbereit bleiben, wenn das Aufwachsen von Material die Ringöffnung nicht soweit verkleinert, daß Werkstücke an der Beschichtung hängen bleiben und damit nicht mehr entnommen werden können.

Demzufolge ist die Erfindung gerichtet auf einen Abschattungsring für scheibenförmige Werkstücke in Plasmabeschichtungsanlagen mit einem Auflagebereich zur Auflage des zu beschichtenden Werkstücks und einem senkrecht zum Auflagebereich angeordneten Kranzring, wobei eine vom Kranzring gebildete Ringöffnung größer ist als das Werkstück und der Abschattungsring dadurch gekennzeichnet ist, daß die Ringöffnung an ihrem Auflagebereich-abgewandten Ende kleiner ist als die Ringöffnung am Auflagebereich-zugewandten Ende, so daß einerseits eine von der Ringöffnung abgewandte Oberfläche des Werkstücks vor einer Beschichtung abgeschirmt ist und daß andererseits während einer vorgegebenen Einsatzdauer des Abschattungsrings in einer Plasmabeschichtungsanlage die Ringöffnung eine effektive Größe behält, bei der eine Entnahme des scheibenförmigen Werkstücks durch das Auflagebereich-abgewandte Ende der Ringöffnung möglich bleibt.

Unter der Ringöffnung ist die Öffnung zu verstehen, die sich innerhalb des Umfangs des Kranzrings befindet.

Unter einer vorgegebenen Einsatzdauer ist die Verbleibdauer des Abschattungsrings in der Plasmabeschichtungsanlage zu verstehen, wobei diese als zeitliche Größe, jedoch ebenso als Zahl der beschichteten Werkstücke gemessen werden kann. Die vorgegebene Einsatzdauer bemißt sich unter anderem nach den Formveränderungen, welche durch Schichtablagerungen am Abschattungsring zustande kommen. Vorgegebene Einsatzdauern richten sich nach weiteren Faktoren beim Betrieb der Plasmabeschichtungsanlage und werden für einen reibungslosen Prozeßablauf vorab festgelegt.

Unter dem Auflagebereich-abgewandten Ende des Kranzrings ist die Seite des Kranzrings zu verstehen, welche nicht in unmittelbarer Verbindung mit dem Auflagebereich des Abschattungsrings steht, während die Auflagebereich zugewandte Seite des Kranzrings diejenige ist, welche mit dem Auflagebereich unmittelbar verbunden ist, sei es durch Anschweißen des Kranzrings an den Auflagebereich oder durch einstückige Ausbildung (Ausfräsen aus dem Vollen) von Kranzring und Auflagebereich.

Der Kranzring weist somit erfindungsgemäß zwei unterschiedliche Öffnungsquerschnitte auf, nämlich einerseits am Auflagebereich zugewandten Ende einen größeren Öffnungsquerschnitt und damit eine größere Ringöffnungsfläche und andererseits am Auflagebereich-abgewandten Ende einen kleineren Ringquerschnitt und somit eine kleinere Ringöffnungsfläche. Auf diese Weise ist es möglich, einen geeigneten seitlichen Abstand des Kranzrings vom flachen Werkstück einzuhalten, während andererseits die Abschattung durch die Verkleinerung der Ringöffnung am Auflagebereich angewandten Ende verbessert werden kann und dadurch eine Beschichtung der Werkstückrückseite unterbunden werden kann.

Unter einer effektiven Größe ist die Fläche der Ringöffnung zu verstehen, welche diese bei Aufsicht auf den Abschattungsring zu einem beliebigen Zeitpunkt aufweist.

Die effektive Größe ändert sich während der Nutzung des Abschattungsrings in einer Plasmabeschichtungsanlage in der Regel, da durch Aufwachsen einer Schicht an der Innenwandung des Kranzrings der Durchmesser des Kranzrings schrumpft. Die Ringöffnung sollte daher in ihrem Auflagebereich-abgewandten Ende so groß sein, daß eine Beschichtung des Kranzrings während der vorgegebenen Einsatzdauer des Abschattungsrings in der Plasmabeschichtungsanlage lediglich eine Verringerung der Ringöffnung bis zu einer effektiven Größe bewirken kann, die eine Entnahme des scheibenförmigen Werkstücks durch das Auflagebereich abgewandte Ende der Ringöffnung noch ermöglicht.

Der Kranzring kann eine Innenwandung aufweisen, die zumindest an ihrem Auflagebereich abgewandten Ende zum Auflagebereich nach innen (das heißt zum Werkstück hin) geneigt ist, so daß die Ringöffnung sich zum Auflagebereich-abgewandten Ende verkleinert. Die Innenwandung kann also insgesamt (über ihre gesamte Höhe) oder nur in einem Teilbereich (an ihrem Auflagebereich-abgewandten Ende) nach innen geneigt sein.

In einer alternativen Ausführungsform kann der Kranzring aufweisen einen Bereich mit einer zum Auflagebereich im wesentlichen senkrechten Innenwandung und einen Aufsatz, der die Ringöffnung im Auflagebereich angewandten Ende verkleinert. Der Aufsatz ermöglicht eine flexiblere Ausgestaltung des Auflagebereich abgewandten Endes des Kranzrings und damit dessen Optimierung im Hinblick auf die angestrebten Ziele. Der Aufsatz weist wiederum eine Fläche auf, welche eine Innenwandung bildet, das heißt zum Werkstück hin orientiert ist. Der Aufsatz kann an dieser Innenwandung zum Auflagebereich nach innen geneigt sein. Auf diese Weise wird nicht nur eine Verkleinerung der Ringöffnung am Auflagebereich abgewandten Ende erreicht, sondern es ist darüber hinaus möglich, die diese verkleinerte Ringöffnung bildende Innenwandung des Aufsatzes individuell auszuformen.

Die Neigung des geneigten Bereichs der Innenwandung kann einen Winkel zum Auflagebereich aufweisen, bei dem eine Schichtbildung auf dem geneigten Bereich während einer vorgegebenen Einsatzdauer in der Plasmabeschichtungsanlage die effektive Größe der Ringöffnung nur soweit verkleinert, daß eine Entnahme des scheibenförmigen Werkstücks durch das Auflagebereich abgewandte Ende der Ringöffnung möglich bleibt. Diese Ausführungsform macht sich die Erkenntnis zunutze, daß an bestimmten Oberflächen, beispielsweise der Innenwandung des Kranzrings oder des Aufsatzes, eine Schichtbildung durch Abscheiden von Material in einer bestimmten Stärke erfolgt. Ist die Innenwandung in einem bestimmten Bereich senkrecht, so verkleinert sich der von einem Mittelpunkt des Auflagebereichs gemessene Abstand bis zur Innenwandung um den genauen Wert der aufgebrachten Schichtdicke. Ist jedoch die Innenwandung geneigt, so geht die Schichtdicke nicht voll in die Verkleinerung des Abstands ein, da die Abstandsverkleinerung nunmehr nicht exakt in Richtung der Abstandsmessung, sondern in einem Winkel dazu erfolgt. Somit ist die Abstandsverkleinerung bei gleicher Schichtdickenbildung bei geneigten Oberflächen kleiner. Hierbei ist es belanglos, ob die geneigte Innenwandung zum Werkstück hin oder davon weg geneigt ist. Bei der in der Erfindung bevorzugten Neigung zum Werkstück hin, also nach innen, in der hier angewendeten Definition, kommt als zusätzlicher Effekt hinzu, daß sich durch die verbesserte Abschirmung der Innenwandung auch die Dicke des während der vorgegebenen Einsatzdauer erfolgten Schichtauftrags verkleinert. Im Ergebnis also führt die Innenneigung dazu, daß man den Kranzring bzw. die Ringöffnung an seinem/ihrem Auflagebereich-abgewandten Ende stärker verkleinern kann, ohne daß eine Werkstückentnahme durch die zusätzlich während der vorgegebenen Einsatzdauer erfolgten Beschichtung verhindert würde.

Für die Ausgestaltung des Querschnitts stehen verschiedene Möglichkeiten zur Verfügung. So kann der Aufsatz als Ring mit einem rechteckigen Querschnitt ausgebildet sein. In dieser einfachen Ausführungsform kann der Aufsatz so auf den Bereich des Kranzrings mit senkrechter Innenwandung aufgesetzt werden, daß er weiter nach innen, das heißt zum Werkstück hin, hineinragt als der Rest des Kranzrings. Der Aufsatz kann auch als Ring mit einem dreieckigen Querschnitt ausgebildet sein, bei dem eine erste Seite parallel zum Auflagebereich verläuft und mit dem Bereich senkrechter Innenwand verbunden ist, eine zweite Seite zum Werkstück orientiert und nach innen geneigt ist und eine dritte Seite die Auflagebereich-abgewandte Kante der zweiten Seite und die Außenkante (das heißt die vom Werkstück abgewandte Seite) der ersten Seite miteinander verbindet. Diese Ausführungsform der Erfindung hat gegenüber einem einfachen rechteckigen Querschnitt den Vorteil, daß, wie oben beschrieben, die Innenwandung des Aufsatzes zum Werkstück hin geneigt ist und die dadurch erzielbaren Vorteile aufweist, während auch die äußere Seite (dritte Seite) eine Neigung aufweist, welche zu einem günstigeren Beschichtungsprofil während des Einsatzes des Abschattungsrings führt.

Der Aufsatz des Abschattungsrings kann weiterhin als Ring mit einem trapezförmigen Querschnitt ausgebildet sein, bei dem eine erste Seite parallel zum Auflagebereich verläuft und mit dem Bereich senkrechter Innenwand verbunden ist, eine zweite Seite zum Werkstück orientiert und nach innen geneigt ist, eine dritte Seite von der Auflagebereich angewandten Kante der zweiten Seite parallel zur ersten Seite nach außen verläuft, und eine vierte Seite die Außenkante der dritten Seite und die Außenkante der ersten Seite miteinander verbindet. Diese, der Verwendung des Dreiecks als Aufsatzquerschnitt ähnliche, Ausführungsform der vorliegenden Erfindung vergrößert die Flexibilität und vereinfacht die Herstellung des Aufsatzes beziehungsweise Aufsatzbereichs. Durch die Einfügung einer weiteren, zur ersten Seite parallelen dritten Seite können die Neigungswinkel der zweiten beziehungsweise der vierten Seite, das heißt der Innenwandung und der Außenwandung, flexibler ausgelegt werden. Zudem ist die Herstellung eines solchen Aufsatzes durch die parallelen Seiten aus einem rechteckigen Ring einfacher als die Herstellung einer dreieckigen Ausgestaltung. Schließlich ist die obere Innenkante der zweiten Seite bei dieser Ausführungsform weniger spitz, was wiederum zu einer vereinfachten Herstellung beiträgt.

Die zweite Seite der zuvor besprochenen Aufsatztypen kann mit dem Auflagebereich einen Winkel von 30 bis 89° bilden, bevorzugt einen Winkel von 45 bis 75°, beispielsweise einen Winkel von etwa 60°.

Auch die vierte Seite des trapezförmigen Aufsatzes ist vorzugsweise nach innen geneigt, wodurch sich ähnlich vorteilhafte Wirkungen wie bei der Verwendung eines dreieckigen Aufsatzes ergeben. Die dritte Seite des dreieckigen Aufsatzes oder bei Verwendung eines trapezförmigen Aufsatzes die vierte Seite des trapezförmigen Aufsatzes, kann mit dem Auflagebereich einen Winkel von 30 bis 80°, vorzugsweise von 35 bis 55°, beispielsweise einen Winkel von 45° bilden.

Der Aufsatz kann auf den Bereich des Kranzrings mit der senkrechten Innenwandung aufgeschweißt, mit diesem verschraubt, verklebt oder sonstwie befestigt sein. In einer bevorzugten Ausführungsform wird der Aufsatz und der Bereich mit der senkrechten Innenwandung allerdings einteilig ausgebildet, beispielsweise durch Fräsen aus einem Werkstück oder durch Drehen.

Auf Grund vorgegebener Erfahrungswerte bezüglich des Auflagerns einer Beschichtung auf dem Abschattungsring während seines Einsatzes in einer Plasmabeschichtungsanlage läßt sich bestimmen, wie groß der Abstand des Kranzrings von dem scheibenförmigen Werkstück sein sollte. Vorzugsweise ist jeder Schnittpunkt einer Lotlinie von einer Innenkante des Auflagebereich-abgewandten Endes des Kranzrings, beziehungsweise des Aufsatzes, mit dem Auflagebereich zumindest 3 bis 6 mm vom nächsten Punkt des Rands des Werkstücks entfernt. Von jedem Punkt dieser Innenkante läßt sich eine Lotlinie direkt auf den Auflagebereich fällen. Bei Aufsicht kann man dann feststellen, wie weit ein eingelegtes scheibenförmiges Werkstück von dem Punkt, an dem die Lotlinie auf den Auflagebereich auftrifft, bis zu dem diesem Schnittpunkt nächstgelegenen Punkt an der Umrandung des scheibenförmigen Werkstückes entfernt ist. Dieser Abstand sollte mindestens 3 bis 6 mm betragen, um auch nach Auflagern einer Schicht auf die Innenkante das problemlose Entfernen des scheibenförmigen Werkstücks aus dem Auflagebereich durch die Ringöffnung hindurch zu ermöglichen.

Auch für den Zustand nach der vorgegebenen Einsatzdauer lassen sich Erfahrungswerte angeben, welche von den Fertigungstoleranzen sowie den Plazierungstoleranzen der Werkstücke und Beschichtungsunterschieden abhängig sind. Daher wird es bevorzugt, daß jeder Schnittpunkt einer Lotlinie von einer Innenkante einer während einer vorgegebenen Einsatzdauer auf einer Seite des Auflagebereichs abgewandten Endes des Kranzrings abgelagerten Schicht mit dem Auflagebereich zumindest 1 mm vom nächsten Punkt des Randes des Werkstücks entfernt ist.

Der Abstand parallel zum Auflagebereich von einer Auflagebereich abgewandten Innenkante des Kranzrings bis zu einem Übergangspunkt der Innenwandung des Kranzrings mit dem Auflagebereich kann 30 bis 60 Prozent des senkrechten Abstands von der Auflagebereich-abgewandten Innenkante bis zum Auflagebereich entsprechen. Hieraus ergibt sich ein bevorzugter Winkel des Gesamtüberhangs, den der Kranzring gegenüber seiner Basis nach innen aufweist. Vorzugsweise entspricht der Abstand parallel zum Auflagebereich von der Auflagebereich-abgewandten Innenkante des Kranzrings bis zum Übergangspunkt der Innenwandung des Kranzrings mit dem Auflagebereich etwa 45 Prozent des senkrechten Abstands von der Auflagebereich-abgewandten Innenkante bis zum Auflagebereich.

Grundsätzlich kann die Ringöffnung, welche durch den auf den Auflagebereich aufgesetzten Kranzring gebildet wird, unterschiedlichste Formen annehmen und muß zur Erfüllung der erfindungsgemäßen Verbesserungen eines Abschattungsrings in der Form dem jeweils zu beschichtenden Werkstück angepaßt sein. Vorzugsweise ist die Ringöffnung im wesentlichen kreisförmig. Dies erlaubt die Verwendung für kreisförmige Werkstücke wie beispielsweise Wafern.

Im Auflagebereich des Abschattungsrings können Aussparungen angeordnet sein, welche unter dem Werkstück liegen und den Durchtritt von Werkstückhebern ermöglichen.

Weiterhin kann der Auflagebereich eine Scheibenöffnung aufweisen, die kleiner ist als die Auflagefläche des Werkstücks, so daß dieses mit Randbereichen der von der Ringöffnung abgewandten Oberfläche auf dem Auflagebereich aufliegt und sich seine zentralen Bereiche über der Scheibenöffnung befinden.

Vorzugsweise ist das scheibenförmige Werkstück ein Wafer, beispielsweise ein in der Halbleiterindustrie verwendeter Wafer.

Schließlich wird es noch bevorzugt, daß der Kranzring bei Verwendung üblicher Wafer oder ähnlicher flacher Werkstücke eine Höhe über dem Auflagebereich von 10 bis 30 mm aufweist.

Im folgenden soll die Erfindung anhand bevorzugter Ausführungsbeispiele näher erläutert werden, wobei auf die beigefügten Zeichnungen Bezug genommen werden wird, in denen folgendes dargestellt ist:
Figur 1 zeigt, wie beschrieben, eine vorbekannte Halteanordnung für Werkstücke mit einem Abschattungsring;
Figur 2 zeigt eine erfindungsgemäße Ausführungsform des verbesserten Abschattungsrings;
Figur 3 zeigt einen Querschnitt durch den erfindungsgemäßen Abschattungsring der Figur 2 längs der Schnittlinie III;
Figur 4 zeigt einen erfindungsgemäßen Abschattungsring in Aufsicht zur Verdeutlichung der bevorzugten Bemaßungen; und
Figur 5 zeigt verschiedene Ausführungsformen des Kranzrings im Querschnitt.

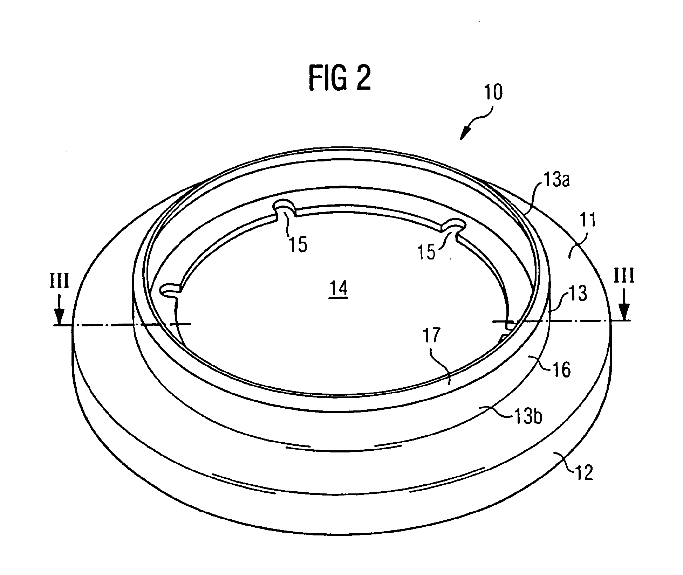

Figur 2 zeigt eine Ausführungsform des erfindungsgemäßen Abschattungsrings. Der Abschattungsring 10 besteht aus einem Auflagebereich 11, der sich sowohl außerhalb als auch innerhalb einer Schnittlinie mit dem im wesentlichen senkrechten gestellten Kranzring 13 befindet und welcher von einer seitlichen Schürze 12 umgeben ist. Der Kranzring 13 umgrenzt eine Ringöffnung 14. In dieser bevorzugten Ausführungsform weist auch der Auflagebereich eine Öffnung (Scheibenöffnung) auf, an deren Ränder Aussparungen 15 angebracht sind, durch die Hebestifte ein scheibenförmiges Werkstück absenken oder anheben können. Der Kranzring 13 besteht aus einem Bereich im wesentlichen senkrechter Innen- oder Außenwand 16 sowie einem Aufsatzbereich 17. Wie ersichtlich, neigt sich der trapezförmig ausgestattete Aufsatzbereich 17 nach innen zur Ringöffnung hin.

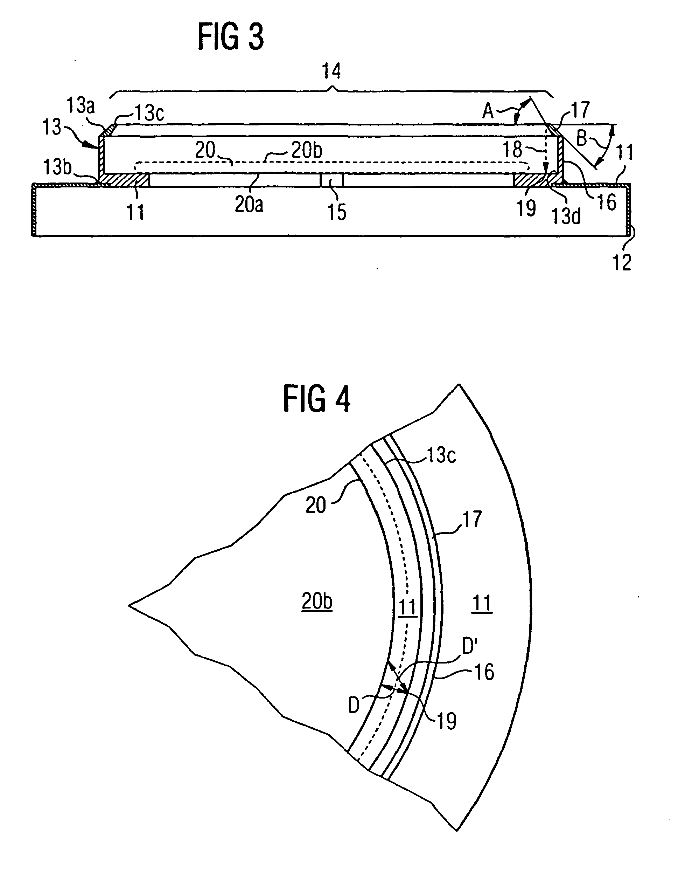

Figur 3 zeigt den in Figur 2 perspektivisch dargestellten Abschattungsring im Querschnitt längs der in Fig. 2 gezeigten Schnittlinie III-III. Gleiche Bezugszeichen kennzeichnen hierbei gleiche Elemente. Der Kranzring 13 besteht aus einem, im Querschnitt betrachtet, im wesentlichen senkrecht verlaufenden Bereich 16 mit einer ebenfalls senkrechten Innenwandung, und einem Aufsatz 17, der im vorliegenden Ausführungsbeispiel trapezoid ausgeführt ist. Der Kranzring 13 weist ein Auflagebereich abgewandtes Ende 13a und ein Auflagebereich zugewandtes Ende 13b auf und verfügt über eine oben und innen liegende Innenkante 13c. Die Innenseite des Aufsatzes 17 steht in einem Winkel A zum Auflagebereich 11, während die Außenseite des Aufsatzes 17 in einem Winkel B zum Auflagebereich 11 geneigt ist. Wenn man von einem beliebigen Punkt der Innenkante 13c eine Lotlinie 18 auf den Auflagebereich 11 fällt, so bekommt man einen Schnittpunkt 19 der Lotlinie mit dem Auflagebereich 11. Der Übergangspunkt 13d zwischen der Innenwandung und dem Auflagebereich 11 dient als Referenzpunkt zur Bestimmung des Überhangs der Innenkante 13c über den Kranzring und der Bestimmung des Winkelüberhangs der Innenkante 13c über den Übergangspunkt. Der Übergangspunkt 13d ist eine rundumlaufende Kante.

Im gestrichelten Umriß dargestellt ist ein flaches Werkstück 20, beispielsweise ein Wafer mit einer unteren Oberfläche 20a, welche vor einer Beschichtung geschützt werden soll und einer oberen Oberfläche 20b, die beschichtet werden soll.

Figur 4 zeigt einen Ausriß aus dem erfindungsgemäßen Abschattungsring in Aufsicht. Diese Darstellung soll die bevorzugten räumlichen Verhältnisse eines Werkstücks und des erfindungsgemäßen Abschattungsrings verdeutlichen. Der Kranzring 13 reicht bis zu einer Innenkante 13c. Wird von dieser ein Lot auf den Auflagebereich 11 gefällt, so ergibt sich ein Schnittpunkt 19. Dieser muß zumindest einen Abstand D, vorzugsweise 3 bis 6 mm, von einer Randkante des zu beschichtenden Werkstücks 20b einhalten. Der Abstand D muß jedenfalls so bemessen sein, daß auch beim Aufwachsen einer Schicht auf die Innenseite des Aufsatzes 17, was in der Figur 4 durch eine gestrichelte Linie dargestellt ist, genügend Platz zum Zuführen und Herausheben der Werkstücke 20 übrig bleibt. In einer bevorzugten Ausführungsform sollte der Abstand auch nach Erreichen der maximalen Schichtdicke beim Ende der Einsatzdauer zumindest 1 mm betragen. Zur Verdeutlichung sei noch einmal angemerkt, daß Abstand D der kleinstmögliche Abstand eines Schnittpunkts 19 zu einem Randpunkt des Werkstücks 20 ist. Die Verwendung anderer Abstände, wie beispielsweise D', das in einem Winkel zum Abstand D gemessen worden ist, ist nicht von Relevanz.

Andererseits muß der Abstand D so bemessen sein, daß der gewünschte Effekt einer Abschirmung der Randbereiche der Rückseite 20a des Werkstücks 20 noch erreicht werden kann. Es ist somit wünschenswert, möglichst nahe mit der Innenkante 13c an die Minimalgrenze des Abstands heranzugehen, bei der ein Herausheben des Werkstücks nach Beschichtung, also nach dem Ende der Einsatzdauer, nicht mehr möglich wäre.

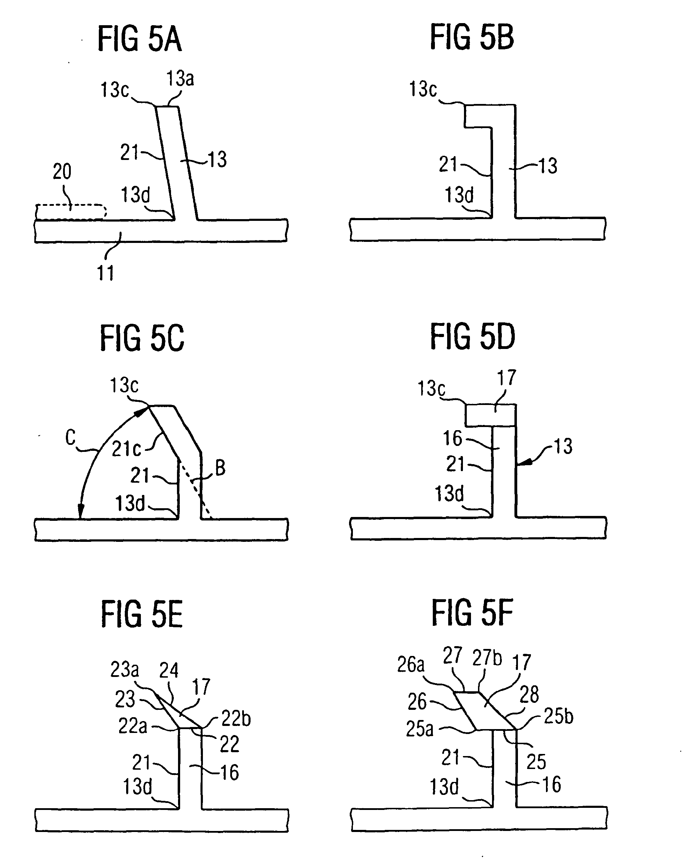

Figur 5 zeigt verschiedene erfindungsgemäße Ausführungsformen des Kranzrings des Abschattungsrings. Figur 5A zeigt eine einfache Ausführungsform der vorliegenden Erfindung, bei der der Kranzring 13 lediglich mit seiner Innenwand 21 zum Werkstück 20 hin nach innen geneigt ist. Es ist auch vorstellbar, daß der Kranzring 13 zu seinem Auflagebereich abgewandten Ende 13a hin dicker wird, und somit beispielsweise eine Innenwand 21 hat, welche nach innen geneigt ist, sowie eine Außenwand, welche im wesentlichen senkrecht auf dem Auflagebereich 11 steht.

Figur 5B zeigt eine weitere Ausführungsform der vorliegenden Erfindung, bei der der Kranzring 13 an seinem oberen Bereich senkrecht nach innen abgeknickt ist. Mithin besteht der Kranzring 13 aus einem im wesentlichen senkrechter Innenwand sowie einem nach innen verlaufenden Auflagebereich-abgewandten Ende mit einer ebenfalls im wesentlichen senkrechten Innenwand.

Figur 5C zeigt eine Ausführungsform, bei der ein oberer Bereich des Kranzrings 13 um einen Winkel C, der nicht 90° ist, gegenüber dem Auflagebereich 11 abgewinkelt ist. Neben dem Bereich im wesentlichen senkrechter Innenwand 21 findet sich somit ein Bereich der Innenwand 21a, welche nach innen hin und zum Werkstück geneigt ist.

Die Figuren 5D bis 5F zeigen Ausführungsformen der vorliegenden Erfindung, welche einen Aufsatz beinhalten. Dieser Aufsatz kann auch einstückig mit dem Bereich 16 des Kranzrings ausgeführt sein. In Figur 5D wird eine Ausführungsform mit einem rechteckigen Aufsatz 17 gezeigt, dessen Innenkante 13c auf Grund der Breite des Aufsatzes 17 gegenüber der Innenwand 21 des Kranzrings 13 nach innen versetzt ist. In Figur 5E ist eine Ausführungsform der vorliegenden Erfindung gezeigt, bei der der Aufsatz 17 dreieckig ausgeführt ist. Der dreieckige Aufsatz verfügt über eine erste Seite 22, eine zweite Seite 23, die nach innen zum Werkstück hin geneigt ist und über eine Innenkante 22a, die mit der ersten Seite 22 verbunden ist, sowie eine dritte Seite 24, welche erste Seite 22 und zweite Seite 23 miteinander an den Innenkanten 23a und der Außenkante 22b verbindet. Die erste Seite 22 kann abweichend von der hier gezeigten Ausführungsform auch breiter sein als der Bereich 16 des Kranzrings 13 und entweder nach innen oder nach außen (bezüglich des Werkstücks betrachtet) über den Bereich 16 hinausragen.

Dies ist beispielsweise in Figur 5F der Fall, die allerdings einen trapezförmigen Aufsatz zeigt. Dieser weist im Querschnitt eine erste Seite 25 auf, welche mit dem Bereich 16 des Kranzrings 13 in Verbindung steht sowie eine zweite Seite 26, welche nach innen zum Werkstück hinweist und die um einen Winkel geneigt gegenüber dem Aufsatzbereich 11 ist. Die Verbindungskante zwischen der ersten Seite 25 und der zweiten Seite 26 ist die Innenkante 25a. Von der Auflagebereich abgewandten Kante 26a der zweiten Seite 26 erstreckt sich die dritte Seite 27 parallel zur ersten Seite 25 wiederum nach außen, das heißt vom Werkstück weg. Die vierte Seite 28 verbindet schließlich die dritte Seite 27 mit der ersten Seite 25 über die Außenseite 27b und die Außenkante der ersten Seite 25b.

Die vorliegende Erfindung optimiert die Abschattungsmöglichkeiten von Abschattungsringen und unterbindet Ablagerungen des Beschichtungsmaterials auf der rückwärtigen Oberfläche eines Flachwerkstücks. Der Abschattungsring ist leicht herzustellen und so auslegbar, daß er mit existierenden Plasmabeschichtungsanlagen integrierbar ist.

### Bezugszeichenliste

- 10: Abschattungsring
- 11: Auflagebereich
- 12: Kragen
- 13: Kranzring
- 13a: Auflagebereich-abgewandtes Ende des Kranzrings
- 13b: Auflagebereich-zugewandtes Ende des Kranzrings
- 13c: Auflagebereich-abgewandte Kante des Kranzrings
- 13d: Übergangspunkt der Innenwandung mit dem Auflagebereich
- 14: Ringöffnung
- 15: Aussparungen
- 16: senkrechter Wandbereich des Kranzrings
- 17: Aufsatz
- 18: Lotlinie
- 19: Schnittpunkt
- 20: Werkstück
- 20a: Zu beschichtende Oberseite des Werkstücks
- 20b: Unterseite des Werkstücks
- 21: Innenwandung des Kranzrings
- 21a: Geneigter Bereich der Innenwandung
- 22: Erste Seite des Dreieckaufsatzes
- 22a: Innenkante der ersten Seite
- 22b: Aussenkante der ersten Seite
- 23: Zweite Seite des Dreieckaufsatzes
- 23a: Auflagebereich-abgewandte Kante der zweiten Seite
- 24: Dritte Seite des Dreieckaufsatzes
- 25: Erste Seite des Trapezaufsatzes
- 25a: Innenkante der ersten Seite
- 25b: Aussenkante der ersten Seite
- 26: Zweite Seite des Trapezaufsatzes
- 26a: Auflagebereich-abgewandte Kante der zweiten Seite
- 27: Dritte Seite des Trapezaufsatzes
- 27b: Aussenkante der dritten Seite
- 28: Vierte Seite des Trapezaufsatzes

- A: Winkel zwischen geneigter Innenseite und Auflagebereich
- B: Winkel zwischen geneigter Aussenseite des Aufsatzes und Auflagebereich
- C: Winkel zwischen Innenwandung und Auflagebereich
- D: senkrechter Abstand Schnittpunkt zur Aussenkante Werkstück
- D': schräger Abstand Schnittpunkt zur Aussenkante Werkstück

## Patentansprüche

1. Abschattungsring (10) für scheibenförmige Werkstücke (20) in Plasmabeschichtungsanlagen mit
einem Auflagebereich (11) zur Auflage des zu beschichtenden Werkstücks (20); und
einem senkrecht zum Auflagebereich angeordneten Kranzring (13), wobei eine vom Kranzring (13) gebildete Ringöffnung (14) größer ist als das Werkstück (20),
**dadurch gekennzeichnet, daß** die Ringöffnung (14) an ihrem Auflagebereich-abgewandten Ende (13a) kleiner ist als die Ringöffnung (14) am Auflagenbereich-zugewandten Ende (13b), so daß einerseits eine von der Ringöffnung (14) abgewandte Oberfläche (20b) des Werkstücks (20) vor einer Beschichtung abgeschirmt ist und daß andererseits während einer vorgegebenen Einsatzdauer des Abschattungsrings (10) in einer Plasmabeschichtungsanlage die Ringöffnung (14) eine effektive Größe behält, bei der eine Entnahme des scheibenförmigen Werkstücks (20) durch das Auflagebereich-abgewandten Ende (13a) der Ringöffnung (14) möglich bleibt.

2. Abschattungsring (10) nach Anspruch 1, **dadurch gekennzeichnet, daß** die Ringöffnung (14) an ihrem Auflagebereich-abgewandten Ende (13a) so groß ist, daß eine Beschichtung des Kranzrings (13) während der vorgegebenen Einsatzdauer des Abschattungsrings (10) in der Plasmabeschichtungsanlage lediglich eine Verringerung der Ringöffnung (14) bis zu einer effektiven Größe bewirken kann, die eine Entnahme des scheibenförmigen Werkstücks (20) durch das Auflagebereich-abgewandte Ende (13a) der Ringöffnung (14) ermöglicht.

3. Abschattungsring (10) nach Anspruch 1 oder 2, **dadurch gekennzeichnet, daß** der Kranzring (13) eine Innenwandung (21) aufweist, die zumindest an ihrem Auflagebereich-abgewandten Ende (13a) zum Auflagebereich (11) nach innen geneigt ist, so daß die Ringöffnung (14) sich zum Auflagebereich-abgewandten Ende (13a) verkleinert.

4. Abschattungsring (10) nach einem der Ansprüche 1 bis 3, **dadurch gekennzeichnet, daß** der Kranzring (13) aufweist einen Bereich mit einer zum Auflagebereich im wesentlichen senkrechten Innenwandung (16) und einen Aufsatz (17), der die Ringöffnung (14) am Auflagebereich-abgewandten Ende (13a) verkleinert.

5. Abschattungsring (10) nach Anspruch 4, **dadurch gekennzeichnet, daß** der Aufsatz (17) an einer Innenwandung (23, 26) zum Auflagebereich (11) nach innen geneigt ist.

6. Abschattungsring (10) nach einem der Ansprüche 3 oder 5, **dadurch gekennzeichnet, daß** die Neigung des geneigten Bereichs (21a) der Innenwandung (21) einen Winkel (C) zum Auflagebereich (11) aufweist, bei dem eine Schichtbildung auf dem geneigten Bereich (21a) während einer vorgegebenen Einsatzdauer in der Plasmabeschichtungsanlage die effektive Größe der Ringöffnung (14) nur so weit verkleinert, daß eine Entnahme des scheibenförmigen Werkstücks (20) durch das Auflagebereich-abgewandten Ende (13a) der Ringöffnung (14) möglich bleibt.

7. Abschattungsring (10) nach einem der Ansprüche 4 bis 6, **dadurch gekennzeichnet, daß** der Aufsatz (17) als Ring mit einem rechteckigen Querschnitt ausgebildet ist.

8. Abschattungsring (10) nach einem der Ansprüche 4 bis 6, **dadurch gekennzeichnet, daß** der Aufsatz (17) als Ring mit einem dreieckigen Querschnitt ausgebildet ist, bei dem eine erste Seite (22) parallel zum Auflagebereich (11) verläuft und mit dem Bereich (16) senkrechter Innenwand (21) verbunden ist, eine zweite Seite (23) zum Werkstück (20) orientiert und nach innen geneigt ist, und eine dritte Seite (24) die Auflagebereich-abgewandte Kante (23a) der zweiten Seite (23) und die Aussenkante (22b) der ersten Seite (22) miteinander verbindet.

9. Abschattungsring (10) nach einem der Ansprüche 4 bis 6, **dadurch gekennzeichnet, daß** der Aufsatz (17) als Ring mit einem trapezförmigen Querschnitt ausgebildet ist, bei dem eine erste Seite (25) parallel zum Auflagebereich (11) verläuft und mit dem Bereich (16) senkrechter Innenwand (21) verbunden ist, eine zweite Seite (26) zum Werkstück (20) orientiert und nach innen geneigt ist, eine dritte Seite (27) von der Auflagebereich-abgewandten Kante (26a) der zweiten Seite (26) parallel zur ersten Seite (25) nach außen verläuft, und eine vierte Seite (28) die Aussenkante (27b) der dritten Seite (27) und die Aussenkante (25b) der ersten Seite (25) miteinander verbindet.

10. Abschattungsring (10) nach Anspruch 8 oder 9, **dadurch gekennzeichnet, daß** die zweite Seite (23, 26) mit dem Auflagebereich (11) einen Winkel (A) von 30° bis 89° bildet.

11. Abschattungsring (10) nach Anspruch 10, **dadurch gekennzeichnet, daß** die zweite Seite (23, 26) mit dem Auflagebereich (11) einen Winkel (A) von 45° bis 75° bildet.

12. Abschattungsring (10) nach Anspruch 10 oder 11, **dadurch gekennzeichnet, daß** die zweite Seite (23, 26) mit dem Auflagebereich (11) einen Winkel (A) von etwa 60° bildet.

13. Abschattungsring (10) nach einem der Ansprüche 8 bis 12, **dadurch gekennzeichnet, daß** die vierte Seite (28) des trapezförmigen Aufsatzes nach innen geneigt ist.

14. Abschattungsring (10) nach Anspruch 13, **dadurch gekennzeichnet, daß** die dritte Seite (24) des dreieckigen Aufsatzes oder die vierte Seite (28) des trapezförmigen Aufsatzes mit dem Auflagebereich (11) einen Winkel (B) von 30° bis 80° bildet.

15. Abschattungsring (10) nach Anspruch 14, **dadurch gekennzeichnet, daß** die dritte Seite (24) des dreieckigen Aufsatzes oder die vierte Seite (28) des trapezförmigen Aufsatzes mit dem Auflagebereich (11) einen Winkel (B) von 35° bis 55° bildet.

16. Abschattungsring (10) nach Anspruch Anspruch 14 oder 15, **dadurch gekennzeichnet, daß** die dritte Seite (24) des dreieckigen Aufsatzes oder die vierte Seite (28) des trapezförmigen Aufsatzes mit dem Auflagebereich (11) einen Winkel (B) von etwa 45° bildet.

17. Abschattungsring (10) nach einem der Ansprüche 4 bis 16, **dadurch gekennzeichnet, daß** der Aufsatz (17) und der Bereich (16) mit der senkrechten Innenwandung (21) einteilig ausgebildet sind.

18. Abschattungsring (10) nach einem der Ansprüche 1 bis 17, **dadurch gekennzeichnet, daß** jeder Schnittpunkt (19) einer Lotlinie (18) von einer Innenkante (23a, 26a) des Auflagebereich-abgewandten Endes (13a) des Kranzrings (13) mit dem Auflagebereich (11) zumindest 3 bis 6 mm vom nächsten Punkt des Rands des Werkstücks (20) entfernt ist.

19. Abschattungsring (10) nach einem der Ansprüche 1 bis 18, **dadurch gekennzeichnet, daß** jeder Schnittpunkt (19) einer Lotlinie von einer Innenkante einer während einer vorgegebenen Einsatzdauer auf einer Seite (23, 26) des Auflagebereich-abgewandten Endes (13a) des Kranzrings (13) abgelagerten Schicht mit dem Auflagebereich (11) zumindest 1 mm vom nächsten Punkt des Rands des Werkstücks (20) entfernt ist.

20. Abschattungsring (10) nach einem der Ansprüche 1 bis 19, **dadurch gekennzeichnet, daß** der Abstand parallel zum Auflagebereich (11) von einer Auflagebereich-abgewandten Innenkante (13c, 23a, 26a) des Kranzrings (13) bis zu einem Übergangspunkt (13d) der Innenwandung (21) des Kranzrings (13) mit dem Auflagebereich (11) 30 % bis 60 % des senkrechten Abstands von der Auflagebereich-abgewandten Innenkante (13c, 23a, 26a) bis zum Auflagebereich (11) entspricht.

21. Abschattungsring (10) nach Anspruch 20, **dadurch gekennzeichnet, daß** der Abstand parallel zum Auflagebereich (11) von der Auflagebereich-abgewandten Innenkante (13c, 23a, 26a) des Kranzrings (13) bis zum Übergangspunkt (13d) der Innenwandung (21) des Kranzrings (13) mit dem Auflagebereich (11) etwa 45 % des senkrechten Abstands von der Auflagebereich-abgewandten Innenkante (13c, 23a, 26a) bis zum Auflagebereich (11) entspricht.

22. Abschattungsring (10) nach einem der Ansprüche 1 bis 21, **dadurch gekennzeichnet, daß** die Ringöffnung (14) im wesentlichen kreisförmig ist

23. Abschattungsring (10) nach einem der Ansprüche 1 bis 22, **dadurch gekennzeichnet, daß** im Auflagebereich (11) Aussparungen (15) angeordnet sind, welche unter dem Werkstück (20) liegen und den Durchtritt von Werkstückhebern ermöglichen.

24. Abschattungsring (10) nach einem der Ansprüche 1 bis 23, **dadurch gekennzeichnet, daß** der Auflagebereich (11) eine Scheibenöffnung aufweist, die kleiner ist als eine Auflagefläche des Werkstücks (20), so daß dieses mit Randbereichen der von der Ringöffnung (14) abgewandten Oberfläche auf dem Auflagebereich (11) aufliegt und deren zentrale Bereiche sich über der Scheibenöffnung befinden.

25. Abschattungsring (10) nach einem der Ansprüche 1 bis 24, **dadurch gekennzeichnet, daß** das scheibenförmige Werkstück (20) ein Wafer ist.

26. Abschattungsring (10) nach einem der Ansprüche 1 bis 25, **dadurch gekennzeichnet, daß** der Kranzring (13) eine Höhe über dem Auflagebereich (11) von 10 bis 30 mm aufweist.

## Claims

1. Shadow ring (10) for disc-shaped workpieces (20) in plasma coating devices, having
a support region (11) for supporting the workpiece (20) to be coated; and
a crown ring (13) arranged perpendicular to the support region, a ring opening (14) formed by the crown ring (13) being larger than the workpiece (20),
**characterized in that** at its end (13a) averted from the support region the ring opening (14) is smaller than at its end (13b) facing the support region such that, on the one hand, a surface (20b), averted from the ring opening (14), of the workpiece (20) is shielded before coating and that, on the other hand, during a prescribed use time of the shadow ring (10) in a plasma coating device the ring opening (14) retains an effective size in the case of which it remains possible to remove the disc-shaped workpiece (20) through the end (13a), averted from the support region, of the ring opening (14).

2. Shadow ring (10) according to Claim 1, **characterized in that** at its end (13a) averted from the support region the ring opening (14) is so large that coating the crown ring (13) during the prescribed use time of the shadow ring (10) in the plasma coating device can effect only a reduction in the ring opening (14) down to an effective size which enables the disc-shaped workpiece (20) to be removed through the end (13a), averted from the support region, of the ring opening (14).

3. Shadow ring (10) according to Claim 1 or 2, **characterized in that** the crown ring (13) has an inner wall (21) which lies inclined inwards towards the support region (11), at least at its end (13a) averted from the support region, such that the ring opening (14) decreases towards the end (13a) averted from the support region.

4. Shadow ring (10) according to one of Claims 1 to 3, **characterized in that** the crown ring (13) has a region with an inner wall (16) substantially perpendicular to the support region, and an attachment (17) which reduces the ring opening (14) at the end (13a) averted from the support region.

5. Shadow ring (10) according to Claim 4, **characterized in that** the attachment (17) is inclined inwards towards the support region (11) at an inner wall (23, 26).

6. Shadow ring (10) according to either of Claims 3 and 5, **characterized in that** the inclination of the inclined region (21a) of the inner wall (21) is at an angle (C) to the support region (11) in the case of which formation of a layer on the inclined region (21a) during a prescribed use time in the plasma coating device reduces the effective size of the ring opening (14) only to the extent that it remains possible to remove the disc-shaped workpiece (20) through the end (13a), averted from the support region, of the ring opening (14).

7. Shadow ring (10) according to one of Claims 4 to 6, **characterized in that** the attachment (17) is designed as a ring having a rectangular cross section.

8. Shadow ring (10) according to one of Claims 4 to 6, **characterized in that** the attachment (17) is designed as a ring having a triangular cross section in the case of which a first side (22) runs parallel to the support region (11) and is connected to the region (16) of the vertical inner wall (21), a second side (23) is oriented towards the workpiece (20) and inclined inwards, and a third side (24) interconnects the edge (23a), averted from the support region, of the second side (23) and the outer edge (22b) of the first side (22).

9. Shadow ring (10) according to one of Claims 4 to 6, **characterized in that** the attachment (17) is designed as a ring having a trapezoidal cross section, in the case of which a first side (25) runs parallel to the support region (11) and is connected to the region (16) of the vertical inner wall (21), a second side (26) oriented at the workpiece (20) and inclined inwards, a third side (27) runs outwards from the edge (26a), averted from the support region, of the second side (26) in a fashion parallel to the first side (25), and a fourth side (28) interconnects the outer edge (27b) of the third side (27) and the outer edge (25b) of the first side (25).

10. Shadow ring (10) according to Claim 8 or 9, **characterized in that** the second side (23, 26) forms an angle (A) of 30° to 89° with the support region (11).

11. Shadow ring (10) according to Claim 10, **characterized in that** the second side (23, 26) forms an angle (A) of 45° to 75° with the support region (11).

12. Shadow ring (10) according to Claim 10 or 11, **characterized in that** the second side (23, 26) forms an angle (A) of approximately 60° with the support region (11).

13. Shadow ring (10) according to one of Claims 8 to 12, **characterized in that** the fourth side (28) of the trapezoidal attachment is inclined inwards.

14. Shadow ring (10) according to Claim 13, **characterized in that** the third side (24) of the triangular attachment, and the fourth side (28) of the trapezoidal attachment forms an angle (B) of 30° to 80° with the support region (11).

15. Shadow ring (10) according to Claim 14, **characterized in that** the third side (24) of the triangular attachment, or the fourth side (28) of the trapezoidal attachment forms an angle (B) of 35° to 55° with the support region (11).

16. Shadow ring (10) according to Claim 14 or 15, **characterized in that** the third side (24) of the triangular attachment, or the fourth side (28) of the trapezoidal attachment forms an angle (B) of approximately 45° with the support region (11).

17. Shadow ring (10) according to one of Claims 4 to 16, **characterized in that** the attachment (17) and the region (16) with the vertical inner wall (21) are designed in one piece.

18. Shadow ring (10) according to one of Claims 1 to 17, **characterized in that** each point of intersection (19) of a perpendicular (18) from an inside edge (23a, 26a) of the end (13a), averted from the support region, of the crown ring (13) with the support region (11) is removed by at least 3 to 6 mm from the next point on the edge of the workpiece (20).

19. Shadow ring (10) according to one of Claims 1 to 18, **characterized in that** each point of intersection (19) of a perpendicular from an inside edge of a layer, deposited during a prescribed use time on a side (23, 26) of the end (13a), averted from the support region, of the crown ring (13), with the support region (11) is removed by at least 1 mm from the nearest point of the edge of the workpiece (20).

20. Shadow ring (10) according to one of Claims 1 to 19, **characterized in that** the distance parallel to the support region (11) from an inside edge (13c, 23a, 26a), averted from the support region, of the crown ring (13) up to a transition point (13d) of the inner wall (21) of the crown ring (13) with the support region (11) corresponds to 30% to 60% of the vertical distance from the inside edge (13c, 23a, 26a), averted from the support region, up to the support region (11).

21. Shadow ring (10) according to Claim 20, **characterized in that** the distance parallel to the support region (11) from the inside edge (13c, 23a, 26a), averted from the support region, of the crown ring (13) up to the transition point (13d) of the inner wall (21) of the crown ring (13) with the support region (11) corresponds approximately to 45% of the vertical distance from the inside edge (13c, 23a, 26a), averted from the support region, up to the support region (11).

22. Shadow ring (10) according to one of Claims 1 to 21, **characterized in that** the ring opening (14) is substantially circular.

23. Shadow ring (10) according to one of Claims 1 to 22, **characterized in that** cutouts (15) which lie below the workpiece (20) and permit the passage of workpiece lifters, are arranged in the support region.

24. Shadow ring (10) according to one of Claims 1 to 23, **characterized in that** the support region (11) has a disc opening which is smaller than the support surface of the workpiece (20) such that the latter rests with the edge regions of the surface, averted from the ring opening (14), on the support region (11) and the central regions thereof are above the disc opening.

25. Shadow ring (10) according to one of Claims 1 to 24, **characterized in that** the disc-shaped workpiece (20) is a wafer.

26. Shadow ring (10) according to one of Claims 1 to 25, **characterized in that** the crown ring (13) has a height of 10 to 30 mm above the support region (11).

## Revendications

1. Anneau (10) de protection pour des pièces (20) en forme de disque dans des installations de revêtement par plasma comprenant
une partie (11) de support pour supporter la pièce (20) à revêtir ; et
une couronne (30) disposée perpendiculairement à la partie de support, une ouverture (14) annulaire formée par la couronne (13) étant plus grande que la pièce (20),
**caractérisé en ce que** l'ouverture (14) annulaire est, à son extrémité (13a) éloignée de la partie de support, plus petite que l'ouverture (14) annulaire à l'extrémité (13b) tournée vers la partie de support de sorte que, d'une part, une surface (20b) de la pièce (20), éloignée de l'ouverture (14) annulaire, est protégée d'un revêtement et de sorte que, d'autre part, pendant une durée d'utilisation prescrite de l'anneau (10) de protection dans une installation de revêtement par plasma, l'ouverture (14) annulaire conserve une dimension efficace, pour laquelle il reste possible d'enlever la pièce (20) en forme de disque par l'extrémité (13a) de l'ouverture (14) annulaire, éloignée de la partie de support.

2. Anneau (10) de protection suivant la revendication 1, **caractérisé en ce que** l'ouverture (14) annulaire est si grande à son extrémité (13a) éloignée de la partie de support qu'un revêtement de la couronne (13) peut, pendant la durée d'utilisation prescrite de l'anneau (10) de protection dans l'installation de revêtement par plasma, provoquer seulement une diminution de l'ouverture (14) annulaire jusqu'à une dimension efficace qui rend possible d'enlever la pièce (20) en forme de disque par une extrémité (13a) de l'ouverture (14) annulaire, éloignée de la partie de support.

3. Anneau (10) de protection suivant la revendication 1 ou 2, **caractérisé en ce que** la couronne (13) a une paroi (21) intérieure qui est inclinée vers l'intérieur par rapport à la partie (11) de support au moins à son extrémité (13a) éloignée de la partie de support de manière à rapetisser l'ouverture (14) annulaire vers l'extrémité (13a) éloignée de la partie de support.

4. Anneau (10) de protection suivant l'une des revendications 1 à 3, **caractérisé en ce que** la couronne (13) a une partie ayant une paroi (16) intérieure sensiblement perpendiculaire à la partie de support et un couronnement (17) qui rapetisse l'ouverture (14) annulaire à l'extrémité (13a) éloignée de la partie de support.

5. Anneau (10) de protection suivant la revendication 4, **caractérisé en ce que** le couronnement (17) est sur une paroi (23, 26) intérieure incliné vers l'intérieur par rapport à la partie (11) de support.

6. Anneau (10) de protection suivant l'une des revendications 3 ou 5, **caractérisé en ce que** l'inclinaison de la partie (21a) inclinée de la paroi (21) intérieure fait un angle (C) par rapport à la partie (11) de support, dans lequel une formation de couche sur la partie (21a) inclinée, pendant une durée d'utilisation prescrite dans l'installation de revêtement par plasma, ne rapetisse la dimension efficace de l'ouverture (14) annulaire qu'autant qu'il reste possible d'enlever la pièce (20) en forme de disque par l'extrémité (13a) de l'ouverture (14) annulaire, éloignée de la partie de support.

7. Anneau (10) de protection suivant l'une des revendications 1 à 6, **caractérisé en ce que** le couronnement (17) est constitué sous la forme d'un anneau ayant une section transversal rectangulaire.

8. Anneau (10) de protection suivant l'une des revendications 4 à 6, **caractérisé en ce que** le couronnement (17) est constitué sous la forme d'une anneau ayant une section transversale triangulaire, dans lequel un premier côté (22) s'étend parallèlement à la partie (11) de support et est relié à la partie (16) de paroi (21) intérieure verticale, un deuxième côté (23) est orienté vers la pièce (20) et est incliné vers l'intérieur et un troisième côté (24) relie entre eux le bord (23a), éloigné de la partie de support, du deuxième côté (23) et le bord (22b) extérieur du premier côté (22).

9. Anneau (10) de protection suivant l'une des revendications 4 à 6, **caractérisé en ce que** le couronnement (17) est constitué sous la forme d'un anneau ayant une section transversale trapézoïdale, dans lequel un premier côté (25) s'étend parallèlement à la partie (11) de support et est relié à la partie (16) de paroi (21) intérieure verticale, un deuxième côté (26) est orienté vers la pièce (20) et est incliné vers l'intérieur, un troisième côté (27) s'étend vers l'extérieur du bord (26a), éloigné de la partie de support, du deuxième côté (26) parallèlement au premier côté (25) et un quatrième côté (28) relie entre eux le bord (27b) extérieur du troisième côté (27) et le bord (25b) extérieur du premier côté (25).

10. Anneau (10) de protection suivant la revendication 8 ou 9, **caractérisé en ce que** le deuxième côté (23, 26) fait avec la partie (11) de support un angle (A) de 30° à 89°.

11. Anneau (10) de protection suivant la revendication 10, **caractérisé en ce que** le deuxième côté (23, 26) fait avec la partie (11) de support un angle (A) de 45° à 75°.

12. Anneau (10) de protection suivant la revendication 10 ou 11, **caractérisé en ce que** le deuxième côté (23, 26) fait avec la partie (11) de support un angle (A) d'environ 60°.

13. Anneau (10) de protection suivant la revendication 8 à 12, **caractérisé en ce que** le quatrième côté (28) du couronnement en forme de trapèze est incliné vers l'intérieur.

14. Anneau (10) de protection suivant la revendication 13, **caractérisé en ce que** le troisième côté (24) du couronnement triangulaire ou le quatrième côté (28) du couronnement trapézoïdal fait avec la partie (11) de support un angle (B) de 30° à 80°.

15. Anneau (10) de protection suivant la revendication 14, **caractérisé en ce que** le troisième côté (24) du couronnement triangulaire ou le quatrième côté (28) du couronnement trapézoïdal fait avec la partie (11) de support un angle (B) de 35° à 55°.

16. Anneau (10) de protection suivant la revendication 14 ou 15, **caractérisé en ce que** le troisième côté (24) du couronnement triangulaire ou le quatrième côté (28) du couronnement trapézoïdal fait avec la partie (11) de support un angle (B) d'environ 45°.

17. Anneau (10) de protection suivant l'une des revendications 4 à 16, **caractérisé en ce que** le couronnement (17) et la partie (16) sont constitués d'un seul tenant avec la paroi (21) intérieure verticale.

18. Anneau (10) de protection suivant l'une des revendications 1 à 17, **caractérisé en ce que** chaque point (19) d'intersection d'une ligne (18) verticale d'un bord (23a, 26a) intérieur de l'extrémité (13a), éloigné de la partie de support, de la couronne (13) avec la partie (11) de support est éloignée au moins de 3 à 6 mm du point suivant du bord de la pièce (20).

19. Anneau (10) de protection suivant l'une des revendications 1 à 18, **caractérisé en ce que** chaque point (19) d'intersection d'une ligne verticale d'un bord intérieur d'une couche déposée pendant une durée d'utilisation prescrite sur un côté (23, 26) de l'extrémité (13a), éloigné de la partie de support, de la couronne (13) avec la partie (11) de support est éloigné d'au moins 1 mm du point le plus proche du bord de la pièce (20).

20. Anneau (10) de protection suivant l'une des revendications 1 à 19, **caractérisé en ce que** la distance, parallèlement à la partie (11) de support, d'un bord (13c, 23a, 26a) intérieur, éloigné de la partie de support, de la couronne (13) jusqu'à un point (13d) de transition de la paroi (11) intérieure de la couronne (13) avec la partie (11) de support représente de 30% à 60% de la distance verticale du bord (13c, 23a, 26a) intérieur, éloigné de la partie de support, à la partie (11) de support.

21. Anneau (10) de protection suivant la revendication 20, **caractérisé en ce que** la distance parallèlement à la partie (11) de support du bord (13c, 23a, 26a) intérieur, éloigné de la partie de support, de la couronne (13) au point (13d) de transition de la paroi (21) intérieure de la couronne (13) avec la partie (11) de support représente environ 45% de la distance verticale du bord (13c, 23a, 26a) intérieur, éloigné de la partie de support, à la partie (11) de support.

22. Anneau (10) de protection suivant l'une des revendications 1 à 21, **caractérisé en ce que** l'ouverture (14) annulaire est sensiblement circulaire.

23. Anneau (10) de protection suivant l'une des revendications 8 à 12, **caractérisé en ce que** dans la partie (11) de support sont ménagés des évidement (15) qui se trouvent sous la pièce (20) et qui rendent possible le passage d'élévateurs de pièce.

24. Anneau (10) de protection suivant l'une des revendications 1 à 23, **caractérisé en ce que** la partie (11) de support a une ouverture pour les disques, qui est plus petite qu'une surface de support de la pièce (20), de sorte que celle-ci s'applique, par des parties de bord de la surface éloignée de l'ouverture (14) annulaire, sur la partie (11) de support et ses parties centrales se trouvent sur l'ouverture pour des disques.

25. Anneau (10) de protection suivant l'une des revendications 1 à 24, **caractérisé en ce que** la pièce (20) en forme de disque est une tranche.

26. Anneau (10) de protection suivant l'une des revendications 1 à 25, **caractérisé en ce que** la couronne (13) a une hauteur au dessus de la partie (11) de support de 10 à 30 mm.
